# EUROPEAN PATENT APPLICATION

(11) **EP 4 672 518 A1**
(43) Date of publication of application: **31.12.2025**
(21) Application number: 24760167.7
(22) Date of filing: 08.02.2024
(51) Int. Cl.: H01S 5/11, H04B 10/548

(54) **TWO-DIMENSIONAL PHOTONIC CRYSTAL LASER**

(30) Priority: 21.02.2023 JP 2023025154
(71) Applicant: Kyoto University, Kyoto-shi, Kyoto 606-8501 (JP)
(72) Inventor: NODA, Susumu, Kyoto-shi, Kyoto 606-8501 (JP); INOUE, Takuya, Kyoto-shi, Kyoto 606-8501 (JP); MORITA, Ryohei, Kyoto-shi, Kyoto 606-8501 (JP)
(74) Representative: Hoeger, Stellrecht & Partner Patentanwälte mbB
(86) International application number: PCT/JP2024/004428
(87) International publication number: WO 2024/176865

(57) **Abstract**

Provided is a two-dimensional photonic crystal laser capable of transmitting a signal by laser light at a high S/N ratio. A two-dimensional photonic crystal laser (10) includes an active layer (11), a two-dimensional photonic crystal layer (12) having a two-dimensional photonic crystal structure in which a different refractive index portion (122), which is a portion having a refractive index different from a refractive index of a plate-like base member (121) laminated directly with the active layer (11) or with another layer, is two-dimensionally and periodically disposed in the base member (121), the two-dimensional photonic crystal layer (12) having a plurality of electric current injection regions (1201, 1202) having different resonance frequencies from each other, and an electric current supply unit (split electrode (172)) configured to supply a signal electric current in which a ratio of electric current intensity between the plurality of electric current injection regions (1201, 1202) changes with time into each of the plurality of electric current injection regions.

## Description

### TECHNICAL FIELD

The present invention relates to a two-dimensional photonic crystal laser (also referred to as "two-dimensional photonic crystal surface emitting laser") in which a two-dimensional photonic crystal is used for amplifying light.

### BACKGROUND ART

In addition to the recent spread of portable information terminals, in the future, with the spread of the so-called "Internet of Things", in which various objects such as automobiles are connected to the Internet, there is a concern that frequency resources of a radio frequency band used for communication will be depleted. As one of the countermeasures, use of laser light for wireless communication (referred to as "free space optical communication") has been studied. Such free space optical communication is assumed to be applied to, for example, communication between base stations of mobile phones, communication between the ground and a satellite, communication between satellites, or the like. In order to realize such free space optical communication, a laser light source having a large output and a small divergence angle of an emitted laser beam is required. Examples of such a laser light source include a two-dimensional photonic crystal laser (for example, see Non Patent Literature 1).

A two-dimensional photonic crystal laser includes an active layer, a two-dimensional photonic crystal layer, and a pair of electrodes provided so as to sandwich the active layer and the two-dimensional photonic crystal layer. The active layer generates light emission with a specific wavelength band upon being supplied with carriers (positive holes, electrons) from the electrode pair. The two-dimensional photonic crystal layer has a configuration including a plate-shaped base member in which different refractive index portions whose refractive index differs from that of the base member are periodically disposed two-dimensionally. The different refractive index portions include air holes (air) formed in the base member, or a member different from the material of the base member. In such a two-dimensional photonic crystal laser, out of light generated in the active layer, only light of a predetermined resonance frequency resonates and laser oscillates in the two-dimensional photonic crystal layer, and laser light is emitted from a surface of the two-dimensional photonic crystal layer, where the resonance frequency is determined by the length of the period (period length) in which the different refractive index portions are disposed in the two-dimensional photonic crystal layer, the area ratio (volume ratio if the thickness is considered) of the different refractive index portions, the refractive index of the base member, and other factors. Here, the resonance wavelength in the two-dimensional photonic crystal layer is determined by the period length, but even if the resonance wavelength is the same, the resonance frequency has a different value if the average refractive index of the entire two-dimensional photonic crystal layer is different. Since the volume of the different refractive index portions affects the average refractive index of the entire two-dimensional photonic crystal layer, the volume of the different refractive index portions also affects the resonance frequency.

As an initial experiment of free space optical communication, Non Patent Literature 1 describes that an electric current in which a signal electric current having an amplitude of 0.1 A is superimposed on a DC bias electric current having the magnitude of 2.5 A is passed between electrode pairs of a two-dimensional photonic crystal laser, whereby the intensity of laser light emitted from the two-dimensional photonic crystal laser is detected by a detector 1.1 m away from the laser. From this experiment, it has been confirmed that laser light with modulated intensity is detected corresponding to amplitude modulation of the electric current. That is, an amplitude-modulated electric current which is an electric signal is converted into an intensity-modulated optical signal by the two-dimensional photonic crystal laser, and the optical signal can be received by a detector which is a receiver.

### CITATION LIST

### PATENT LITERATURE

Patent Literature 1: JP 2008-243962 A
Patent Literature 2: WO 2017/150387 A

### NON PATENT LITERATURE

Non Patent Literature 1: S. Ishimura and nine others, "Proposal and Demonstration of Free-Space Optical Communication Using Lens-Free Photonic-Crystal Surface-Emitting Laser", Proceedings European Conference Optical Community, (France), published by European Physical Society, 2022, Th3A.7

### SUMMARY OF INVENTION

### TECHNICAL PROBLEM

In free space optical communication, it is required to use a laser having an optical output power of 1 W or more to realize long-distance communication, and it is required to use a high modulation frequency of 1 GHz or more in order to communicate a large quantity of information. In the two-dimensional photonic crystal laser described in Non Patent Literature 1, it is possible to set the optical output to 1 W or more, but when the modulation frequency is increased, it becomes difficult to increase the amplitude of the signal electric current input to the laser, and the conversion efficiency from the signal electric current to the signal light in the laser also decreases. Accordingly, it is not possible to sufficiently increase the modulation amplitude of the intensity of the laser light, that is, the intensity of the optical signal received by the detector which is a receiver. Therefore, the signal-to-noise ratio (S/N ratio) of the optical signal cannot be sufficiently high.

An object of the present invention is to provide a two-dimensional photonic crystal laser capable of transmitting signals by laser light at a high S/N ratio.

### SOLUTION TO PROBLEM

In order to solve the above problems, according to the present invention, a two-dimensional photonic crystal laser includes:
a) an active layer;
b) a two-dimensional photonic crystal layer having a two-dimensional photonic crystal structure in which a different refractive index portion, which is a portion having a refractive index different from a refractive index of a plate-like base member laminated directly with the active layer or with another layer, is two-dimensionally and periodically disposed in the base member, the two-dimensional photonic crystal layer having a plurality of electric current injection regions having different resonance frequencies from each other; and
c) an electric current supply unit configured to supply a signal electric current in which a ratio of electric current intensity between the plurality of electric current injection regions changes with time into each of the plurality of electric current injection regions.

In the two-dimensional photonic crystal laser according to the present invention, the two-dimensional photonic crystal layer is divided (not physically but virtually) into a plurality of electric current injection regions, and the resonance frequency is made different for each electric current injection region. As described above, in general, in the two-dimensional photonic crystal laser, since the resonance frequency is determined by a period length in which the different refractive index portion is disposed, a volume ratio of the different refractive index portion, the refractive index of the base member, and other factors, the resonance frequencies in each electric current injection region have different values by making the period length and the volume ratio in each of the plurality of electric current injection regions, the refractive index of the base member, or another factor (further specific examples will be described later) different from each other. When the electric current supply unit supplies a signal electric current into each of the plurality of electric current injection regions, the signal electric current is injected into a region of the active layer facing the electric current injection region directly or via another layer, light emission with different intensity corresponding to the magnitude of the signal electric current occurs for each of the regions of the active layer, and light with different intensity for each of the electric current injection regions is introduced into the two-dimensional photonic crystal layer from the active layer. In the present invention, since an intensity ratio between the electric current injection regions of the signal electric current changes with time, the intensity ratio of light between the electric current injection regions also changes with time.

In the present invention, the resonance frequencies of the respective electric current injection regions are different from each other, but when light is simultaneously introduced into the plurality of electric current injection regions, the individual electric current injection regions do not form resonance states different from each other, but one fundamental resonance state is formed in an entire two-dimensional photonic crystal layer, and resonance occurs at one resonance frequency. Hereinafter, the resonance frequency of the fundamental resonance state formed in the entire two-dimensional photonic crystal layer is referred to as "total resonance frequency". The total resonance frequency is determined by the resonance frequency for each electric current injection region determined by the period length, the volume ratio, and the like as described above and the magnitude of an electric current density supplied for each electric current injection region (corresponding to the intensity of light introduced from the active layer). Since a weighting of a contribution of the resonance frequency differs for each electric current injection region depending on the magnitude of the electric current density (light intensity), the total resonance frequency becomes a value closer to the resonance frequency of the electric current injection region having a larger electric current density than the electric current injection region having a smaller electric current density. For example, in a two-dimensional photonic crystal layer having two electric current injection regions, a first electric current injection region having a first resonance frequency and a second electric current injection region having a second resonance frequency, the total resonance frequency becomes closer to the first resonance frequency as a ratio of an electric current density of an electric current supplied to the first electric current injection region to an electric current density of an electric current supplied to the second electric current injection region is increased, and the total resonance frequency becomes closer to the second resonance frequency as the ratio of the electric current density is decreased.

In the present invention, the time-varying signal electric current is supplied to each of the plurality of electric current injection regions in the two-dimensional photonic crystal layer having such characteristics at different magnitudes, thereby applying the temporal change to the total resonance frequency. For example, when an electric current having a peak waveform corresponding to a half cycle of a sine wave is a signal representing "1" and an electric current 0 is a signal representing "0", a signal electric current obtained by superimposing an electric current having such a waveform on a DC electric current having the same magnitude with an amplitude different for each electric current injection region causes a temporal change in which the magnitude of the electric current density is different for each electric current injection region with the half cycle of the sine wave as one cycle, and thereby the total resonance frequency also changes with time. In this manner, a temporal change in the frequency (note that it is not the frequency of the intensity change of the light but the frequency of the light as a wave) of light is imparted to a laser light emitted from the two-dimensional photonic crystal laser according to the present invention.

An optical signal that is laser light to which such a temporal change in frequency is imparted can be detected at a higher S/N ratio (than in the case of Non Patent Literature 1 in which the intensity of light is modulated) using a known method such as a delayed self-homodyne method. Here, the delayed self-homodyne method is a method of dividing a signal (in the present invention, an optical signal to which a temporal change of the frequency of light is imparted) into two, delaying one of the two signals by a predetermined delay time, and then mixing the two signals to extract a difference frequency component, and is known as a method capable of performing high-speed frequency discrimination. In the present invention, a method for detecting the optical signal is not limited to the delayed self-homodyne method, and other methods may be used.

The resonance frequency of each electric current injection region can be typically set based on the period length of a two-dimensional lattice, the volume of the different refractive index portion, and the like after different refractive index portions are disposed in a two-dimensional lattice shape. As the two-dimensional lattice in which the different refractive index portions are disposed, a square lattice, a triangular lattice, a rectangular lattice, a rhombic lattice, or the like can be used. The shorter the period length, the higher the resonance frequency. In addition, the resonance frequency increases: as the volume of different refractive index portions increases when the refractive index of the different refractive index portions is smaller than that of the base member, and as the volume of different refractive index portions decreases when the refractive index of the different refractive index portions is larger than that of the base member. However, if the form of the two-dimensional lattice (square lattice, triangular lattice, etc.) is different in each electric current injection region, one fundamental resonance state cannot be formed in the entire two-dimensional photonic crystal layer, and thus a two-dimensional lattice having the same form is used for each electric current injection region.

Alternatively, the resonance frequency of each electric current injection region can also be set different from each other by setting the average refractive index of each region to a different value, which can be set by configuring the base member and/or the different refractive index portions with different materials for each electric current injection region to. In this case, production is easier when configuring the base member by using different materials for each electric current injection region with making all the different refractive index portions from the same holes (the same material).

Furthermore, the resonance frequency of each electric current injection region can also be set by setting the average refractive index of each electric current injection region to a different value by setting the DC electric current (DC component of the signal electric current) supplied to each electric current injection region as a part of the signal electric current to a different value for each electric current injection region. As the DC component of the signal electric current supplied to the electric current injection region increases, the time average value of a calorific value increases, thereby increasing the temperature of the electric current injection region. Therefore, the average refractive index for each electric current injection region can be adjusted by the magnitude of the DC component of the signal electric current. The smaller the average refractive index, the higher the resonance frequency.

In the two-dimensional photonic crystal laser according to the present invention, it is preferable that:
the signal electric current is modulated at a predetermined modulation frequency, and
the difference between the maximum resonance frequency and the minimum resonance frequency among resonance frequencies in the plurality of electric current injection regions is larger than the modulation frequency. As a result, the temporal change of the frequency of the laser light can be sufficiently increased.

In the two-dimensional photonic crystal laser according to the present invention,
the signal electric current to be supplied to two electric current injection regions of the plurality of electric current injection regions can be an electric current obtained by superimposing, on a DC electric current, a time-varying electric current having either a waveform in which an electric current value maintains a positive or negative value or a waveform in which an electric current value maintains 0 for each predetermined modulation period, in which the time-varying electric current has phases opposite to each other (in other words, one is -1 times that of the other) in the two electric current injection regions.

By using such a signal electric current, data represented by binary values in which the waveform in which the electric current value of the time-varying electric current maintains a positive or negative value is "1" and the waveform in which the electric current value maintains 0 is "0" can be transmitted for each modulation period. The DC electric current may have the same value or a different value for each electric current injection region. By setting the DC electric current to a different value for each electric current injection region, the resonance frequency of each electric current injection region may be set as described above.

Alternatively, in the two-dimensional photonic crystal laser according to the present invention, it is also possible to adopt a configuration in which
the signal electric current supplied to one of the plurality of electric current injection regions is an electric current in which a time-varying electric current having one of a waveform in which an electric current value maintains a positive or negative value and a waveform in which the electric current value maintains 0 is superimposed on a DC electric current having a first magnitude for each predetermined modulation period, and
the signal electric current supplied to another one of the plurality of electric current injection regions is a DC electric current having a second magnitude.

Also in this case, data represented by binary values in which the waveform in which the electric current value of the time-varying electric current maintains a positive or negative value is "1" and the waveform in which the electric current value maintains 0 is "0" can be transmitted for each modulation period. In addition, the first magnitude and the second magnitude in relation to the DC electric current may be the same or different values. The resonance frequency of each electric current injection region may be set by these magnitudes.

### ADVANTAGEOUS EFFECTS OF INVENTION

According to the present invention, it is possible to obtain a two-dimensional photonic crystal laser capable of transmitting a signal by laser light at a high S/N ratio.

### BRIEF DESCRIPTION OF DRAWINGS

[Fig. 1] A perspective view illustrating an embodiment of a two-dimensional photonic crystal laser according to the present invention.
[Fig. 2] A schematic plan view illustrating a configuration of a two-dimensional photonic crystal layer in the two-dimensional photonic crystal laser of the present embodiment, and a partially enlarged view in which a square region indicated by a solid line in the schematic plan view is enlarged.
[Fig. 3] A partially enlarged view illustrating another example of the configuration of the two-dimensional photonic crystal layer in the two-dimensional photonic crystal laser of the present embodiment.
[Fig. 4] A partially enlarged view illustrating still another example of the configuration of the two-dimensional photonic crystal layer in the two-dimensional photonic crystal laser of the present embodiment.
[Fig. 5] A perspective view illustrating a modification of a shape of an electrode in the two-dimensional photonic crystal laser of the present embodiment.
[Fig. 6] A perspective view illustrating another modification of the shape of the electrode in the two-dimensional photonic crystal laser of the present embodiment.
[Fig. 7] A schematic configuration diagram of an information transmission/reception system using the two-dimensional photonic crystal laser of the present embodiment.
[Fig. 8] A graph illustrating a result obtained by obtaining a temporal change of a frequency of a laser light by simulation, the temporal change being obtained when a signal electric current in which a sinusoidal radio-frequency electric current is superimposed on a DC electric current is supplied to the two-dimensional photonic crystal laser of the present embodiment.
[Fig. 9] A graph illustrating a result obtained by obtaining, by simulation, a relationship between a modulation frequency of the sinusoidal radio-frequency electric current and an amplitude of a frequency change of laser light, which is obtained when the signal electric current obtained by superimposing the sinusoidal radio-frequency electric current on the DC electric current is supplied to the two-dimensional photonic crystal laser of the present embodiment.
[Fig. 10] An optical microscope photograph of the two-dimensional photonic crystal laser produced in the present embodiment taken from an upper surface (emission electrode) side.
[Fig. 11] A graph illustrating a result of measuring the temporal change of the frequency of laser light obtained when the signal electric current in which the sinusoidal radio-frequency electric current is superimposed on the DC electric current is supplied to the two-dimensional photonic crystal laser produced in the present embodiment.
[Fig. 12] A graph illustrating a result of measuring a temporal change in an amplitude of an intensity of laser light obtained when the signal electric current in which the sinusoidal radio-frequency electric current is superimposed on the DC electric current is supplied to the two-dimensional photonic crystal laser produced in the present embodiment.
[Fig. 13] A graph illustrating an example (First Specific Example) of a signal electric current that gives information of "1" and "0" supplied to the two-dimensional photonic crystal laser of the present embodiment.
[Fig. 14] A graph illustrating a result obtained by simulation of temporal changes in the intensity of laser light obtained in the First Specific Example.
[Fig. 15] A graph illustrating a result obtained by simulation of temporal changes in the frequency of laser light obtained in the First Specific Example.
[Fig. 16] A graph illustrating a result of obtaining by simulation a signal obtained by a delayed self-homodyne method in the First Specific Example.
[Fig. 17] A graph illustrating another example (Second Specific Example) of the signal electric current that gives information of "1" and "0" supplied to the two-dimensional photonic crystal laser of the present embodiment.
[Fig. 18] A graph illustrating a result obtained by simulation of temporal change in the intensity of laser light obtained in the Second Specific Example.
[Fig. 19] A graph illustrating a result obtained by simulation of temporal change in the frequency of laser light obtained in the Second Specific Example.
[Fig. 20] A graph illustrating a result obtained by simulation of a signal obtained by the delayed self-homodyne method in the Second Specific Example.
[Fig. 21] A graph illustrating a result obtained by simulation of a relationship between a modulation frequency and the amplitude of the temporal change in intensity of laser light, obtained in a modification and a reference example of the Second Specific Example.
[Fig. 22] A graph illustrating a result of measuring the relationship between the modulation frequency and the amplitude of the temporal change in intensity of laser light for the two-dimensional photonic crystal laser produced in the present embodiment.
[Fig. 23] A graph illustrating a result obtained by simulation of a difference in the relationship between the modulation frequency and the amplitude of the temporal change in intensity of laser light, depending on a ratio of magnitudes of DC electric currents supplied to two electric current injection regions, obtained in a modification of the Second Specific Example.

### DESCRIPTION OF EMBODIMENTS

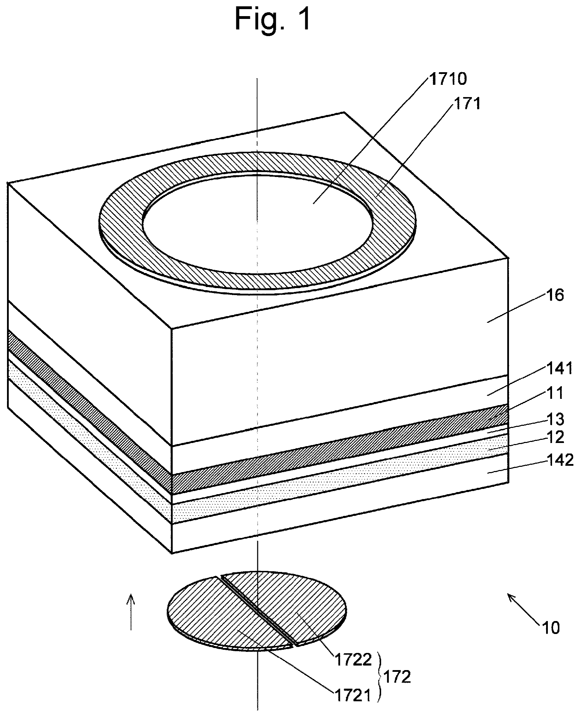

An embodiment of the two-dimensional photonic crystal laser according to the present invention will be described with reference to Figs. 1 to 23.

### (1) Configuration of two-dimensional photonic crystal laser of the present embodiment

As illustrated in Fig. 1, a two-dimensional photonic crystal laser 10 of the present embodiment has a configuration in which an emission-side electrode 171, a substrate 16, a first cladding layer 141, an active layer 11, a spacer layer 13, a two-dimensional photonic crystal layer 12, a second cladding layer 142, and a split electrode 172 are sequentially stacked in the above-described order. However, the order of the active layer 11 and the two-dimensional photonic crystal layer 12 may be opposite to that described above. In Fig. 1, the split electrode 172 is illustrated at a position away from the second cladding layer 142 in order to illustrate a shape of the split electrode 172, but the split electrode 172 is actually in contact with a lower surface of the second cladding layer 142. In addition, in Fig. 1, the emission-side electrode 171 is illustrated as an upper side, and the split electrode 172 is illustrated as a lower side, and expressions of "upper" and "lower" are used for convenience in the following description, but a direction of the two-dimensional photonic crystal laser 10 at the time of use is not limited to the upper side and the lower side. Hereinafter, configurations of the layers and the electrodes will be described. First, a layer having a configuration similar to that of a conventional two-dimensional photonic crystal laser will be described, and then configurations of the two-dimensional photonic crystal layer 12 and two sets of electrodes (the emission-side electrode 171 and the split electrode 172) having configurations specific to the present invention will be described.

The active layer 11 emits light having a predetermined wavelength band when a charge is supplied by an electric current flowing between the emission-side electrode 171 and the split electrode 172. As a material of the active layer 11, for example, an InGaAs/AlGaAs multiple quantum well (emission wavelength band: 935 to 945 nm) can be used.

The first cladding layer 141 and the second cladding layer 142 work to supply electric charges from the emission-side electrode 171 and the split electrode 172 and work to suppress in-plane guided light guided in parallel with the two-dimensional photonic crystal layer 12 within this layer from leaking from the layer. In order to play the former role, for example, an n-type semiconductor (for example, n-type Al_{0.37}Ga_{0.63}As) can be used for the first cladding layer 141, and a p-type semiconductor (for example, p-type Al_{0.37}Ga_{0.63}As) can be used for the second cladding layer 142.

The spacer layer 13 is provided to suppress electrons supplied from the emission-side electrode 171 from passing through the active layer 11 (consequently, combining with positive holes on the emission-side electrode 171 side more so than in the active layer 11) while allowing positive holes supplied from the split electrode 172 to pass and to be introduced into the active layer 11. For example, p-type Al_{0.45}Ga_{0.55}As can be used as a material of the spacer layer 13.

The substrate 16 that is sufficiently thicker than that for other layers is used in order to maintain a mechanical strength of an entire two-dimensional photonic crystal laser 10 and to make a distance between the emission-side electrode 171 and the active layer 11 greater than a distance between the split electrode 172 and the active layer 11. As a material of the substrate 16, an n-type semiconductor is used for the same reason as in the first cladding layer 141.

The emission-side electrode 171 is an annular electrode made of a conductive material. An annular inner side of the emission-side electrode 171 functions as a window 1710 through which a beam of a laser light oscillated in the two-dimensional photonic crystal layer 12 passes as described later.

The split electrode 172 is an electrode formed by dividing a disk-shaped member made of a conductive material and having a diameter smaller than an annular outer diameter (diameter) of the emission-side electrode 171 into two. One of the two split electrodes is referred to as a first split electrode 1721, and the other is referred to as a second split electrode 1722. The split electrode 172 functions as the electric current supply unit. In the present embodiment, the disk-shaped member is divided into two equal parts, but one of the first split electrode 1721 and the second split electrode 1722 may be larger than the other. In the present embodiment, the split electrode 172 divided into two is used, but a split electrode divided into three or more may be used.

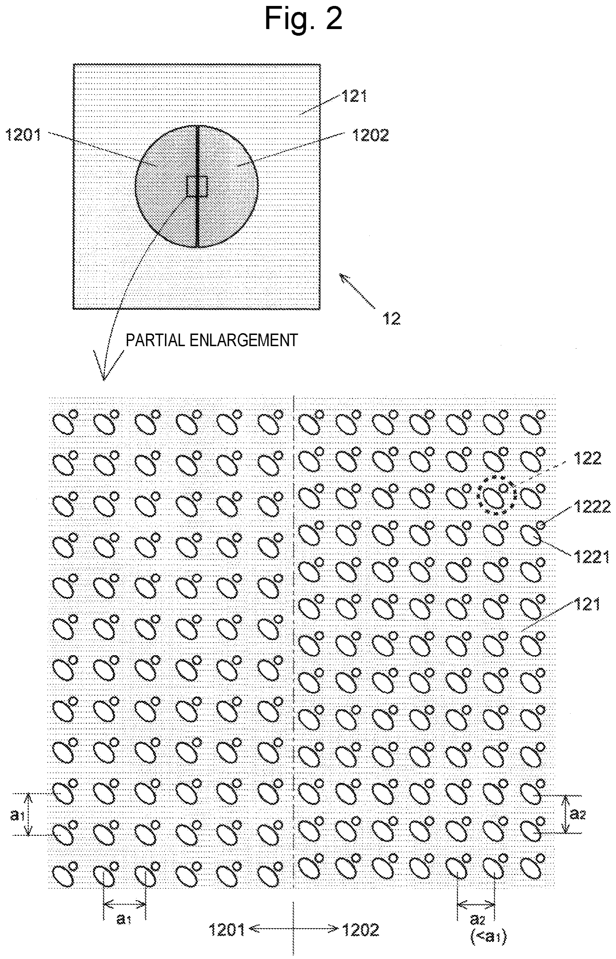

As illustrated in Fig. 2, the two-dimensional photonic crystal layer 12 is formed by disposing a different refractive index portion 122 having a refractive index different from that of a plate-like base member 121 as described later. The base member 121 is made of a p-type semiconductor (for example, p-type GaAs) similarly to the second cladding layer 142 and the spacer layer 13. Although a hole is typically used for the different refractive index portion 122, a member having a refractive index different from a refractive index of the base member 121 may be used instead of the hole.

The two-dimensional photonic crystal layer 12 is provided with a first electric current injection region 1201 and a second electric current injection region 1202 virtually divided into two (not physically divided) in an in-plane direction.

The first electric current injection region 1201 and the second electric current injection region 1202 are provided immediately above the first split electrode 1721 and the second split electrode 1722, respectively, and are regions having substantially the same shape and size as the first split electrode 1721 and the second split electrode 1722, respectively. The electric current flowing between the first split electrode 1721 and the emission-side electrode 171 spreads in the in-plane direction from the first split electrode 1721 toward the emission-side electrode 171, but by making the substrate 16 sufficiently thicker than the second cladding layer 142, the electric current flows in the first electric current injection region 1201 at a position of the two-dimensional photonic crystal layer 12 almost without spreading from an in-plane range of the first split electrode 1721 (in Fig. 1, the substrate 16 is illustrated with a thickness of about several times that of the second cladding layer 142 in order to clearly illustrate a thin layer, but actually, the substrate 16 has a thickness of several tens to one hundred times or more than that of the second cladding layer 142). For the same reason, the electric current flowing between the second split electrode 1722 and the emission-side electrode 171 flows in the second electric current injection region 1202 at the position of the two-dimensional photonic crystal layer 12. As a result, magnitudes of the electric currents flowing through the first electric current injection region 1201 and the second electric current injection region 1202 can be controlled independently of each other using the first split electrode 1721 and the second split electrode 1722.

In the present embodiment, a combination of two holes (a member having a refractive index different from that of the base member 121 may be used as described above) of an elliptic columnar first different refractive index portion 1221 and a columnar second different refractive index portion 1222 having a smaller volume than the elliptic columnar first different refractive index portion is used as one different refractive index portion 122. By using a different refractive index portion in which two holes or members are combined in this manner, it is possible to suppress light from being localized in a partial region in the two-dimensional photonic crystal layer 12 and to oscillate a laser beam by forming a resonance state of the light over a wide range in the two-dimensional photonic crystal layer 12 (see, for example, Patent Literatures 1 and 2). Shapes of the first different refractive index portion 1221 and the second different refractive index portion 1222 are not limited to this example, and may take various shapes (for example, both have an elliptical columnar shape, both have a columnar shape, and either one or both have a triangular columnar shape or a quadrangular columnar shape). In addition, one different refractive index portion may be formed from only one hole or member or three or more holes or members.

In the present embodiment, one different refractive index portion 122 (one set of the first different refractive index portion 1221 and the second different refractive index portion 1222) is disposed at each lattice point of a square lattice in both the first electric current injection region 1201 and the second electric current injection region 1202. A period length of the square lattice of the first electric current injection region 1201 is a₁, the period length of the second electric current injection region 1202 is a₂, and a₂ is smaller than a₁ (a₂ < a₁). As described above, by setting the period lengths in the first electric current injection region 1201 and the second electric current injection region 1202 to different values, when an electric current is supplied to each of the first electric current injection region 1201 and the second electric current injection region 1202, out of light generated in the active layer 11 by the electric current, light corresponding to a resonance frequency determined by the period length of each region resonates, and the resonance frequencies in each region have different values. Specifically, the resonance frequency of the second electric current injection region 1202 having a shorter period length is larger than the resonance frequency of the first electric current injection region 1201.

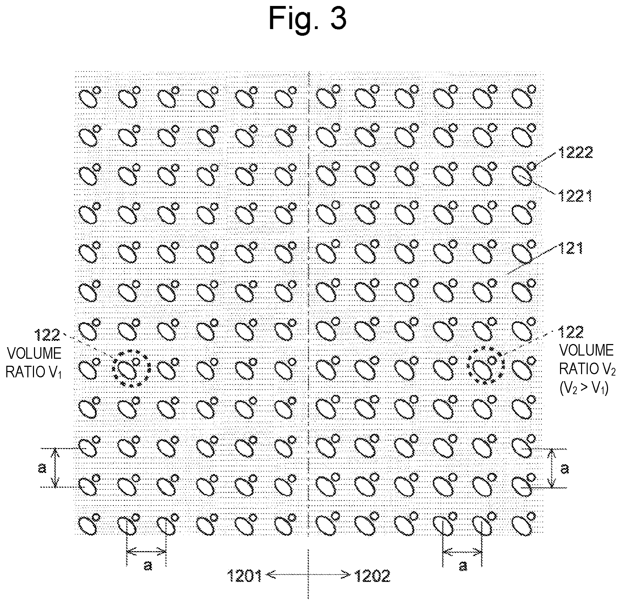

Instead of (or together with) disposing the different refractive index portions 122 with mutually different period lengths between the first electric current injection region 1201 and the second electric current injection region 1202 as in the above example, the different refractive index portions 122 having mutually different volume ratios may be disposed. Here, the volume ratio refers to a ratio of a volume occupied by the different refractive index portions 122 among volumes defined by a product of a unit lattice (a square having a lattice length a × a) of a two-dimensional lattice (a square lattice in this example) in which the different refractive index portions 122 are disposed and a thickness of the two-dimensional photonic crystal layer 12. Fig. 3 illustrates an example in which the different refractive index portions 122 having different volume ratios are disposed between the first electric current injection region 1201 and the second electric current injection region 1202. In this example, the volume ratio of the different refractive index portion 122 disposed in the first electric current injection region 1201 is V₁, the volume ratio of the different refractive index portion 122 disposed in the second electric current injection region 1202 is V₂, and V₂ is larger than V₁ (V₂ > V₁). In this case, the resonance frequency of the second electric current injection region 1202 having a larger volume ratio is larger than the resonance frequency of the first electric current injection region 1201.

Both the period length and the volume ratio may be set to different values between the first electric current injection region 1201 and the second electric current injection region 1202.

In any of the examples described above, the different refractive index portions 122 are disposed in a square lattice shape, but the different refractive index portions 122 may be disposed at lattice points of a two-dimensional lattice of another form such as a triangular lattice shape, a rectangular lattice shape, or a rhombic lattice shape. However, in each electric current injection region, the different refractive index portion 122 is disposed at a lattice point of a two-dimensional lattice of the same form.

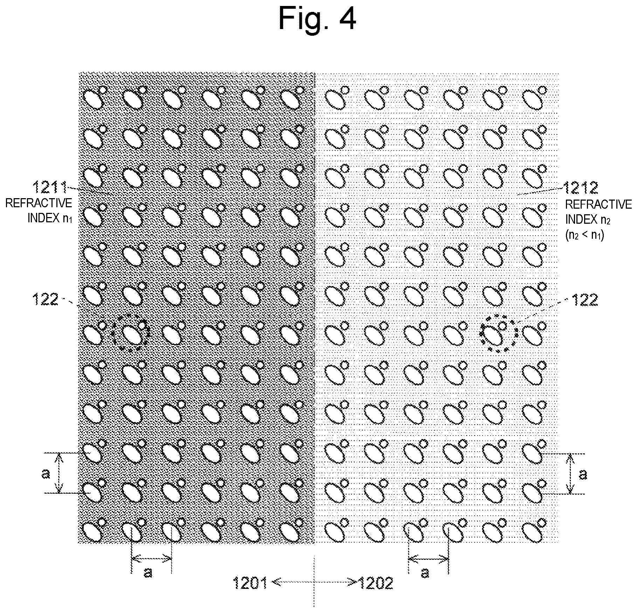

As in the above example, the refractive indexes of the base members 121 in each of the first electric current injection region 1201 and the second electric current injection region 1202 may be made different from each other instead of making the period length or the volume ratio (or both) which are different from each other to be different values. Fig. 4 illustrates an example of using base members 1211 and 1212 having different refractive indexes between the first electric current injection region 1201 and the second electric current injection region 1202. In this example, the refractive index of the base member 1211 of the first electric current injection region 1201 is n₁, the refractive index of the base member 1212 of the second electric current injection region 1202 is n₂, and n₂ is smaller than n₁ (n₂ < n₁). In this case, the resonance frequency of the second electric current injection region 1202 having a smaller refractive index is larger than the resonance frequency of the first electric current injection region 1201. Instead of the refractive index of the base member or together with the refractive index of the base member, the refractive indexes of the different refractive index portions 122 may be made different from each other between the first electric current injection region 1201 and the second electric current injection region 1202. In this case, in at least one electric current injection region, it is necessary to use a member having a refractive index different from that of the base member 121 instead of the hole as the different refractive index portion 122. Therefore, as in the example of Fig. 4, it is easier to produce the base member 121 by making the refractive index (material) of the base member different for each electric current injection region.

Alternatively, as a method of making the refractive index of the base member different for each electric current injection region, for example, by setting an electric current density of a DC electric current flowing for each electric current injection region to a different value, a temperature is set to be different for each electric current injection region.

Furthermore, although the two electric current injection regions (the first electric current injection region 1201 and the second electric current injection region 1202) are provided in each of the examples described so far, three or more electric current injection regions may be provided corresponding to three or more split electrodes as described above, and the different refractive index portions 122 may be disposed at different period lengths or at different volume ratios in each electric current injection region.

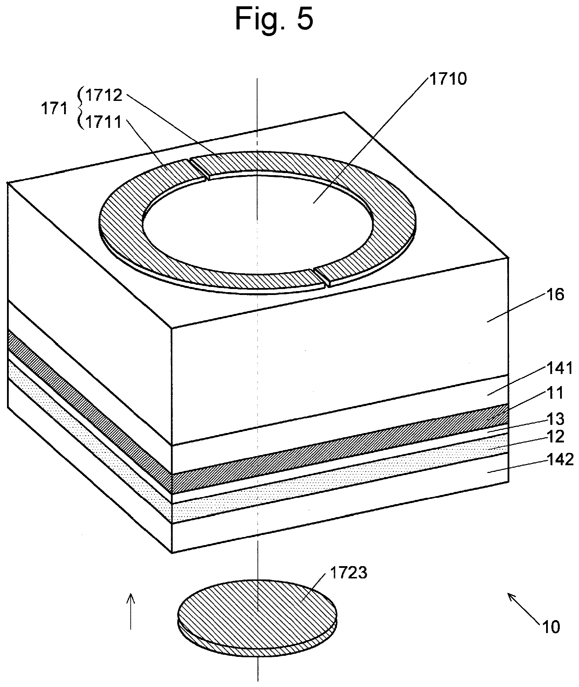

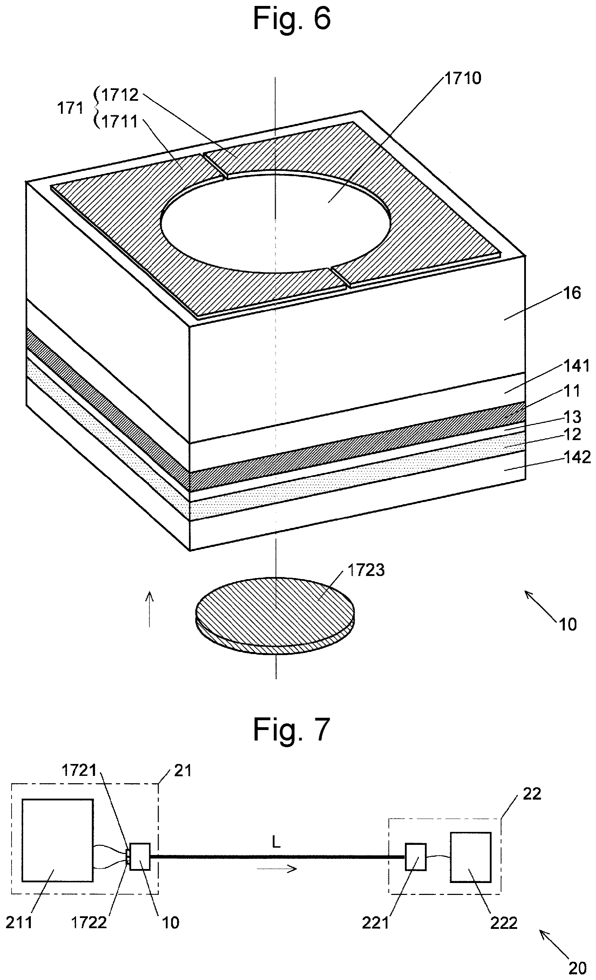

In the example described above, an electrode counter to the emission-side electrode 171 is the split electrode 172, but as illustrated in Fig. 5, the emission-side electrode 171 may be divided into two (or three or more) electrodes (a first emission-side split electrode 1711 and a second emission-side split electrode 1712 in the example of Fig. 5), and an electric current may be independently supplied from each of the electrodes to electric current injection regions different from each other. In this case, the electrode counter to the emission-side electrode 171 (1721, 1722) may be a counter electrode 1723 that is not divided as illustrated in Fig. 5, or may be the split electrode 172 similar to that in Fig. 1. Further, shapes of the emission-side electrode 171 and the counter electrode 1723 (or the split electrodes thereof) are not limited to those described above. For example, in Figs. 1 and 5, as the emission-side electrode 171, one having a donut shape in which both an outer edge and an inner edge (the outer edge of the window 1710) are circular is used, but the outer edge and the inner edge do not need to have the same shape. As illustrated in Fig. 6, the emission-side electrode 171 (the first emission-side split electrode 1711 and the second emission-side split electrode 1712) in which the inner edge (the outer edge of the window 1710) is circular and the outer edge is rectangular may be used. The same applies to a case where the emission-side electrode 171 is not divided.

### (2) Operation of two-dimensional photonic crystal laser of the present embodiment

Next, an operation of the two-dimensional photonic crystal laser 10 of the present embodiment will be described. When the two-dimensional photonic crystal laser 10 is used, a signal electric current generator 211 (see Fig. 7) generates a first signal electric current in which the magnitude of the electric current changes with time in a predetermined waveform and a second signal electric current in which the magnitude of the electric current changes with time in a waveform different from the first signal electric current by power supplied from a power supply (not illustrated). Then, the first signal electric current flows between the emission-side electrode 171 and the first split electrode 1721, and the second signal electric current flows between the emission-side electrode 171 and the second split electrode 1722 (independently of a first split electrode 1721 side).

The first signal electric current is introduced into a region of the active layer 11 facing the first electric current injection region 1201 of the two-dimensional photonic crystal layer 12 (via the spacer layer 13), and in the region of the active layer 11, light emission of an intensity corresponding to the magnitude of the signal electric current occurs, and the light is introduced into the first electric current injection region 1201. Similarly, the second signal electric current is introduced into a region of the active layer 11 facing the second electric current injection region 1202 of the two-dimensional photonic crystal layer 12, and in this region of the active layer 11, light emission of an intensity corresponding to the magnitude of the signal electric current occurs, and the light is introduced into the second electric current injection region 1202.

As a result, one fundamental resonance state is formed in an entire two-dimensional photonic crystal layer 12, and the two-dimensional photonic crystal layer resonates at one total resonance frequency. The total resonance frequency is a frequency between the resonance frequencies of the first electric current injection region 1201 and the second electric current injection region 1202 determined by weighting corresponding to the intensity of light introduced into the first electric current injection region 1201 and the second electric current injection region 1202, the intensity of light being determined by the period length and the volume ratio of the different refractive index portions 122. Laser light is generated by such resonance. The generated laser light passes through the respective layers such as the spacer layer 13 and the window 1710 of the emission-side electrode 171 from a surface of the two-dimensional photonic crystal layer 12, and is emitted to the outside of the two-dimensional photonic crystal laser 10.

Here, as the first signal electric current and the second signal electric current change with time in different waveforms, a ratio of the intensity of light introduced into each of the first electric current injection region 1201 and the second electric current injection region 1202 also changes with time. Therefore, as the weighting of the light intensity between these two electric current injection regions changes with time, the total resonance frequency also changes with time. Therefore, by setting the first signal electric current and the second signal electric current to waveforms (specific examples will be described later) corresponding to some information, the information can be transmitted as a temporal change of the total resonance frequency by a laser light L emitted from the two-dimensional photonic crystal laser 10. Then, the information can be received by receiving the laser light L and outputting a modulation signal corresponding to a temporal change in the frequency of the laser light L (a specific example will be described later) using a detector 221, a computer 222 (see Fig. 7), and the like. Therefore, an information transmission/reception system 20 can be configured by a transmitter 21 having the two-dimensional photonic crystal laser 10 and the like of the present embodiment and a receiver 22 having the detector 221 and the like.

### (3) Specific Examples

Further, description will be made using some specific examples.

### (3-1) Configuration common to specific examples

Here, the volume ratio of the different refractive index portions 122 was set to 11% (among the different refractive index portions 122, the volume ratio of the first different refractive index portion 1221 is 7%, and the volume ratio of the second different refractive index portion 1222 is 4%) in both the first electric current injection region 1201 and the second electric current injection region 1202, and the period length was set to be different between the first electric current injection region 1201 and the second electric current injection region 1202 by any value (different depending on the example) of 0.005%, 0.010%, or 0.015%. The period length a₁ on a first electric current injection region 1201 side was set to 276 nm. Each of the first electric current injection region 1201 and the second electric current injection region 1202 was a semicircle having a diameter of 500 µm. Since the difference between the period lengths a₁ and a₂ is slight, an error may occur at the time of production in the distance (= period length) between the individual different refractive index portions 122, but since the different refractive index portions 122 of several hundred cycles to 1000 cycles or more are disposed in each electric current injection region, it is possible to form such a slight difference in period length when viewed from an average of an entire electric current injection region.

### (3-2) Preliminary simulations and experiments

First, as a preliminary simulation, a case will be examined where a signal electric current in which a sinusoidal radio-frequency electric current is superimposed on a DC electric current is supplied to the two-dimensional photonic crystal laser 10 having the two-dimensional photonic crystal layer 12 in which a two-dimensional periodic structure of such an example is formed. In this simulation, magnitudes of the DC electric currents supplied to the first electric current injection region 1201 and the second electric current injection region 1202 were set to 1.5 A, a maximum amplitude of the radio-frequency electric currents was set to 100 mA, and the radio-frequency electric currents were set to have opposite phases (that is, one magnitude was -1 times the other magnitude) between the first electric current injection region 1201 and the second electric current injection region 1202. A frequency (modulation frequency) of the radio-frequency electric currents was set to 2 GHz. Therefore, a difference Δf (16 GHz, 32 GHz, or 48 GHz) between the resonance frequencies of the first electric current injection region 1201 and the second electric current injection region 1202 is sufficiently larger than the modulation frequency of the signal electric current.

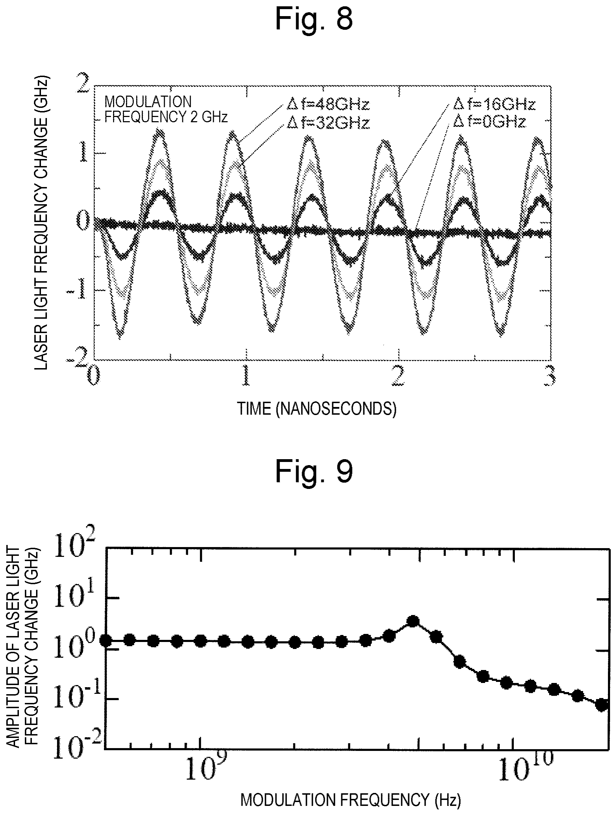

As a result of this simulation, as illustrated in Fig. 8, in any case of a value of Δf, the frequency of the laser light emitted from the two-dimensional photonic crystal laser 10 changes with time in a sinusoidal shape at the same cycle (or modulation frequency) as the change in the magnitude of the signal electric current of the frequency (the vertical axis in Fig. 8 sets the frequency to 0 (origin)) determined by the magnitude of the DC electric current. For comparison, Fig. 8 also illustrates a result of simulation performed in a case where the first electric current injection region 1201 and the second electric current injection region 1202 have the same two-dimensional periodic structure, that is, in a case where Δf is 0. However, in this comparative example, no temporal change in the frequency of the laser light is observed.

Furthermore, in a case where Δf is 48 GHz, a plurality of simulations were performed within a modulation frequency range of 500 MHz to 20 GHz, and an amplitude of the temporal change of the frequency of the laser light was obtained. Fig. 9 illustrates the result. It can be seen that the frequency of the laser light changes with time with an amplitude exceeding 1 GHz in a range where the modulation frequency is smaller than a peak around 5 GHz.

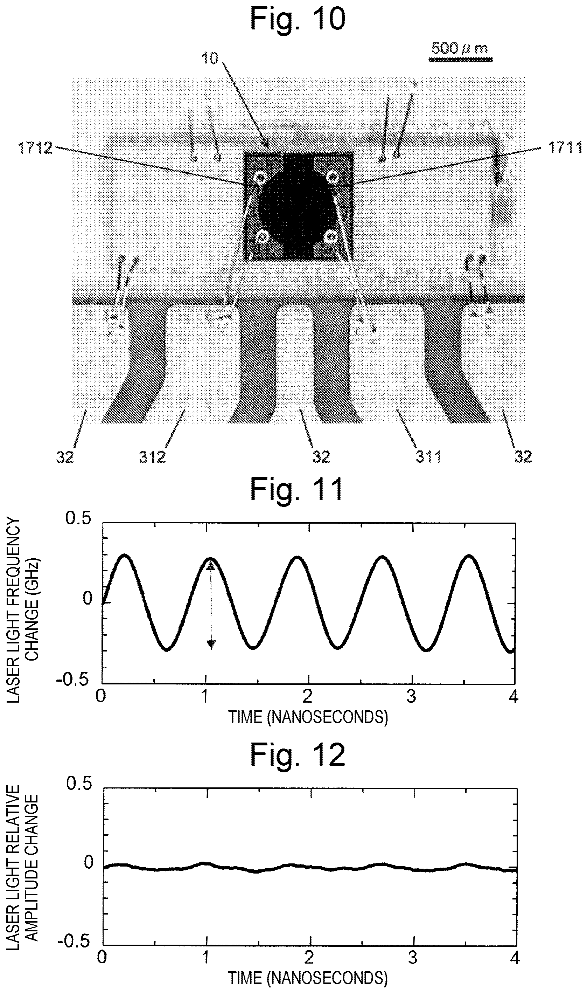

Next, results of an experiment similar to the simulation illustrated in Fig. 8 after the two-dimensional photonic crystal laser 10 of the present embodiment is produced will be described. Fig. 10 shows an optical microscope photograph of the two-dimensional photonic crystal laser 10 prepared in this experiment taken from an upper surface (emission-side electrode 171) side. As the emission-side electrode 171, the first emission-side split electrode 1711 and the second emission-side split electrode 1712 having shapes illustrated in Fig. 6 were used. The first emission-side split electrode 1711 and a first electrode pad 311 were connected by a conductive wire made of gold, and the second emission-side split electrode 1712 and a second electrode pad 312 were connected by a similar conductive wire. A counter electrode 1723 (not visible in Fig. 10; see Fig. 6) was connected to a grounding pad 32, and the grounding pad 32 was grounded. In the two-dimensional photonic crystal layer 12 (not visible in Fig. 10; see Fig. 2), setting the period length a₁ of the square lattice of the first electric current injection region 1201 as a₁ = a₀ + Δa/2 and the period length a₂ of the second electric current injection region 1202 as a₂ = a₀ - Δa/2, a₀ = 278 nm, and Δa = 0.8 × 10⁻⁴a₀ (the difference between a₁ and a₂ is 0.008%). Due to the difference between these period lengths, the difference Δf between the resonance frequencies of the first electric current injection region 1201 and the second electric current injection region 1202 is 26 GHz.

Between each of the first emission-side split electrode 1711, the second emission-side split electrode 1712, and the counter electrode 1723, a signal electric current obtained by superimposing a radio-frequency electric current having a frequency (modulation frequency) of 1.2 GHz and an amplitude of 0.11 A, and phases opposite to each other between the first emission-side split electrode 1711 and the second emission-side split electrode 1712 on a DC electric current having a magnitude of 1.5 A was supplied. Fig. 11 illustrates a result of measuring the temporal change of the frequency of the laser light emitted from the two-dimensional photonic crystal laser 10. Similarly to the result obtained by the simulation, the frequency of the laser light changes with time in a sinusoidal shape. The amplitude of the temporal change of frequency is about 0.6 GHz.

As a result of measuring the amplitude of the intensity of the laser light (note that the amplitude is different from the amplitude of the temporal change of the frequency described above), as illustrated in Fig. 12, the temporal change hardly occurs. As described above, in the two-dimensional photonic crystal laser 10 of the present embodiment, it is possible to impart a periodic temporal change to the frequency of the laser light while suppressing the change in the amplitude of the intensity of the laser light.

### (3-3) First Specific Example

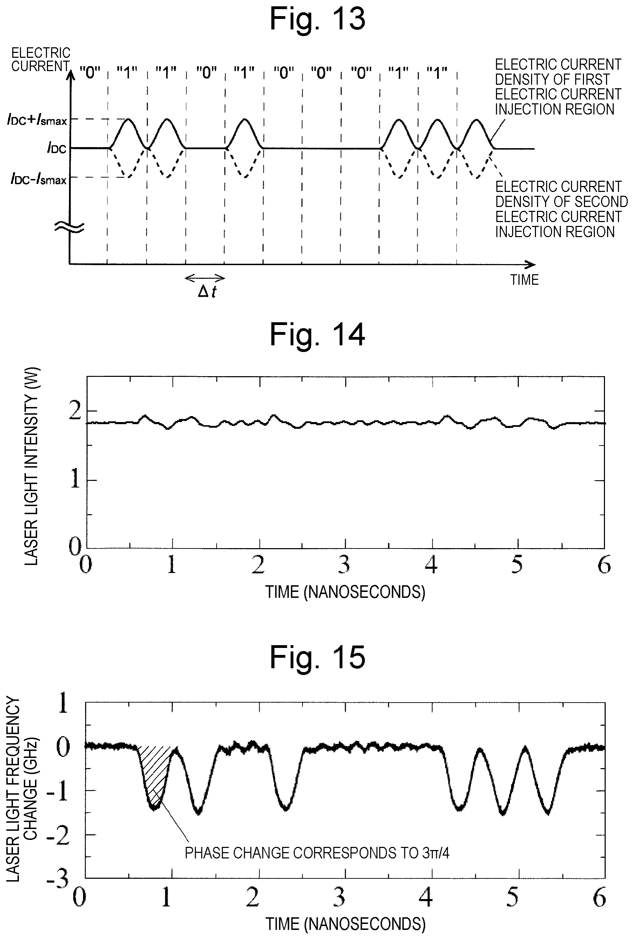

Next, as the First Specific Example, an example will be described in which a signal electric current obtained by superimposing an electric current having binary information of "1" and "0" illustrated in Fig. 13 on a DC electric current is used instead of the radio-frequency electric current used in the previous simulation. In this example, a waveform indicating a temporal change corresponding to a half cycle in which a positive value is maintained out of a sine wave (amplitude Iₛₘₐₓ) represents "1", and a waveform that does not change with time represents "0". A time-varying electric current having such a waveform of "1" or "0" for each modulation period (Δt) is superimposed on a DC electric current having a magnitude I_{DC} corresponding to a column of information of "1" or "0" to be transmitted, and the resulting electric current is used as the first signal electric current. The half cycle of the sine wave was set as the modulation period of the first signal electric current, and the modulation frequency was set to 2 GHz. As the second signal electric current, one in which the waveform of "1" or "0" of the time-varying electric current in the first signal electric current is opposite in phase to the first signal electric current, that is, positive and negative of the electric current are inverted and then superimposed on the DC electric current having the magnitude I_{DC}, was used.

As a result of simulation in which the first signal electric current and the second signal electric current illustrated in Fig. 13 are supplied to the two-dimensional photonic crystal laser 10 of the above example which is Δf = 48 GHz, as illustrated in Fig. 14, the intensity of the emitted laser light does not change significantly with time, although it seems there is a slight variation in the time zone in which the "1" signal is transmitted. Even supposing it is attempted to detect signals of "0" and "1" from such intensity of the laser light, it is difficult to detect the signals at a high S/N ratio.

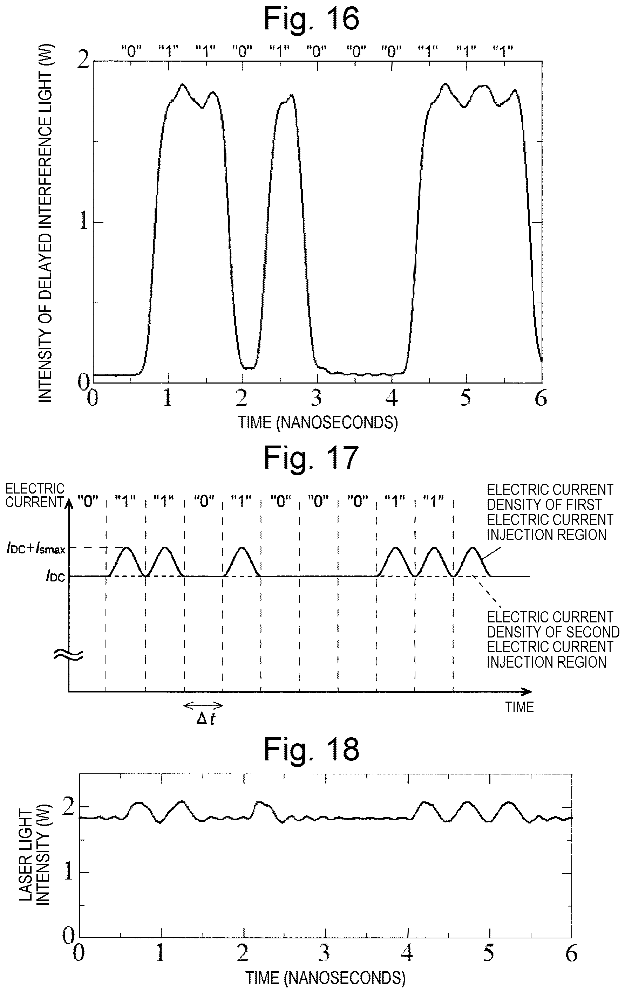

On the other hand, as illustrated in Fig. 15, the frequency of the emitted laser light apparently decreased in the time zone in which the "1" signal was transmitted. When estimated from the temporal change in the frequency of the laser light within one modulation cycle in which the "1" signal is transmitted (the area of a downward peak indicated by hatching in Fig. 15), the temporal change in the frequency of the laser light corresponds to a change of 3π/4 in the phase of the laser light during one modulation cycle of the signal electric current as compared with the case where there is no change. In a case where there is such a change in phase, when an operation of a delayed self-homodyne method is performed in which the signal obtained by delaying an output signal of the laser light by one cycle interferes with the original signal, as illustrated in Fig. 16, in the intensity of the obtained delayed interference light, a significant change in intensity corresponding to the changes in the signals of "1" and "0", which is not observed in the change in intensity of the original laser light with time (Fig. 14), is observed. By acquiring the temporal change of the intensity, it is possible to receive the column of information of "1" or "0" transmitted from the two-dimensional photonic crystal laser 10. A width of the change in the intensity of the delayed interference light exceeds 1 W, and the S/N ratio can be made higher than that in a case where the change in the intensity of the laser light itself is detected. It is desirable that the magnitude of the phase change in one modulation cycle is within a range of π/2 to 3π/2, and π is the most desirable.

### (3-4) Second Specific Example

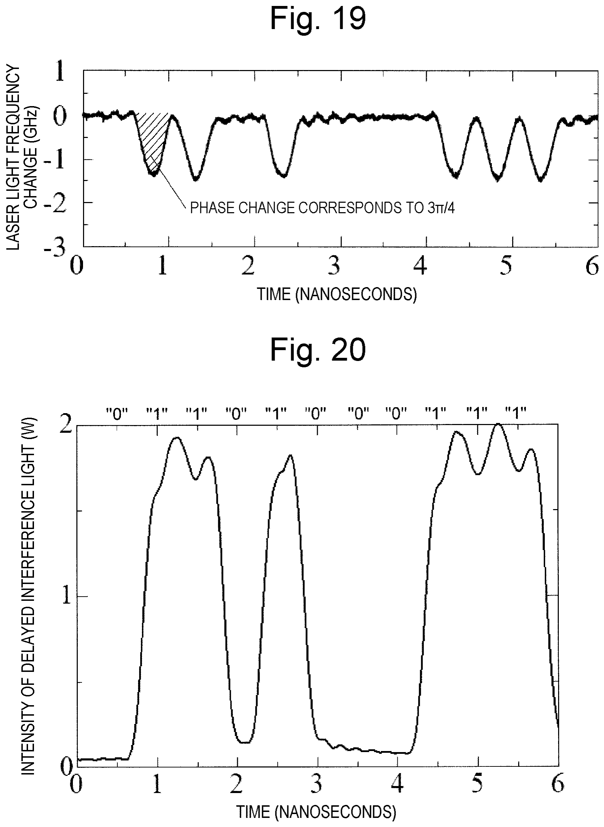

Next, as illustrated in Fig. 17, simulation similar to that of the First Specific Example was performed for a case where an electric current having the waveform of the amplitude Iₛₘₐₓ corresponding to binary information of "1" and "0" similar to that of the First Specific Example being superimposed on a DC electric current having the magnitude I_{DC} was used for the first signal electric current, and only a DC electric current having the magnitude I_{DC} without a temporal change was used for the second signal electric current. As a result, as illustrated in Fig. 18, the intensity of the emitted laser light fluctuates in the time zone in which the "1" signal is transmitted to a slightly greater extent than that in the First Specific Example (Fig. 14), but the magnitude of the fluctuation is smaller by one digit than the magnitude of the fluctuation in the intensity obtained by the delayed self-homodyne method described later. As illustrated in Fig. 19, the frequency of the emitted laser light changes with time close to that in the First Specific Example (Fig. 15). Also in the signal of the delayed interference light obtained by interfering the signal obtained by delaying the output signal of the laser light by one cycle with the original signal, as illustrated in Fig. 20, similarly to the First Specific Example (Fig. 16), a significant temporal change in intensity corresponding to changes in the signals of "1" and "0" can be obtained, and the intensity change can be detected at a high S/N ratio.

### (3-5) Modification of Second Specific Example

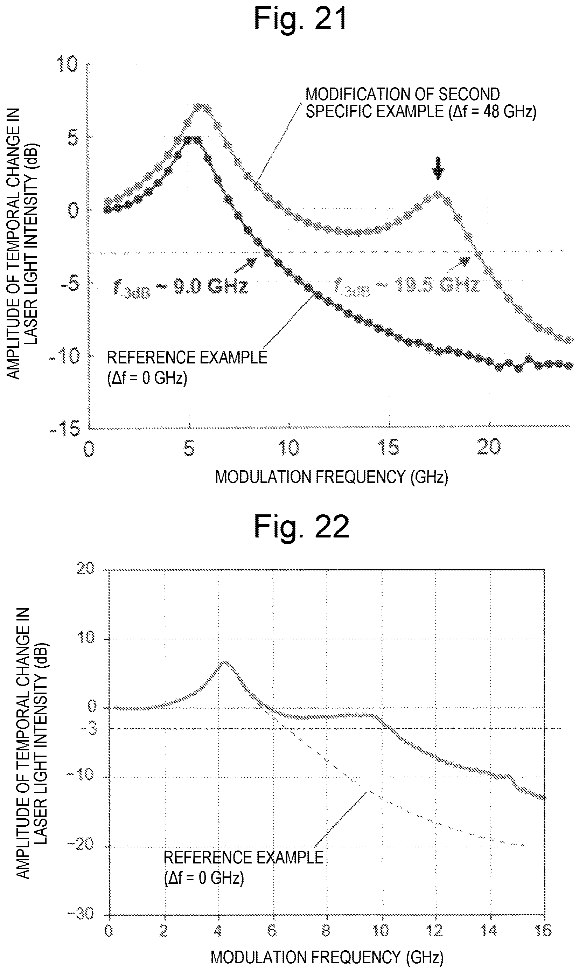

In the Second Specific Example, the frequency of the laser light changes with time, and the intensity of the laser light also changes with time as illustrated in Fig. 18. As described below, a simulation for obtaining the amplitude of the temporal change of the intensity of the laser light while changing the modulation frequency of the first signal electric current was performed. For simplicity, the first signal electric current was obtained by superimposing the sinusoidal radio-frequency electric current on the DC electric current, and the second signal electric current was only the DC electric current. Fig. 21 illustrates a relationship between the modulation frequency obtained by the simulation and the amplitude of the temporal change of the intensity of the laser light in the case of Δf = 48 GHz. Here, for reference, results of simulations performed in a case where the first electric current injection region 1201 and the second electric current injection region 1202 have the same two-dimensional periodic structure, that is, in a case where Δf = 0 GHz, are also shown. In the modification of the Second Specific Example, the amplitude of the temporal change of the intensity of the laser light is larger than that in a reference example over all modulation frequencies, and the S/N ratio can be further increased.

In particular, the amplitude temporarily decreases with a peak around 5 GHz as the modulation frequency increases, but increases from around 12 GHz to a peak around 17 GHz (a peak indicated by a downward arrow in Fig. 21) on a high modulation frequency side. This indicates that, in the modification of the Second Specific Example, information can be transmitted at a higher modulation frequency, that is, an amount of information per unit time that can be transmitted with a high S/N ratio can be increased. For example, the modulation frequency when the amplitude is -3 dB is 9.0 GHz in the reference example, whereas the modulation frequency is 19.5 GHz in the modification of the Second Specific Example.

In addition, an experiment corresponding to the simulation illustrated in Fig. 21 was performed on the two-dimensional photonic crystal laser 10 produced in the present embodiment. In this experiment, a two-dimensional photonic crystal laser 10 having the same structure as that used in the experiments illustrated in Figs. 10 to 12 was produced, except that Δa = 1.6 × 10⁻⁴a₀ (the difference Δf between the resonance frequencies of the first electric current injection region 1201 and the second electric current injection region 1202 is 52 GHz). The electric current to be supplied was a DC electric current having a magnitude of 1.6 A between the first emission-side split electrode 1711 and the counter electrode 1723, and an electric current obtained by superimposing a radio-frequency electric current having an amplitude of 0.06 A on the DC electric current having the magnitude of 1.6 A between the second emission-side split electrode 1712 and the counter electrode 1723. The relationship between the frequency (modulation frequency) of the radio-frequency electric current and the amplitude of the temporal change in the intensity of the laser light was measured. The result is illustrated in Fig. 22. A broken line curve illustrated in Fig. 22 is a simulation value of the reference example in which the different refractive index portions 122 are disposed with the same period length (a₀ = 278 nm) over the entire two-dimensional photonic crystal layer 12 and Δf = 0. The modulation frequency when the amplitude of the temporal change of the intensity of the laser light is -3 dB is about 6.5 GHz in the reference example, but is 10 GHz or more in the present embodiment, and information can be transmitted at a higher modulation frequency in the present embodiment.

The increase in the amplitude of the temporal change of the intensity of the laser light in the high modulation frequency band as described above is considered to be caused by a phenomenon called photon-photon resonance. In the two-dimensional photonic crystal laser 10, since the difference Δf in resonance frequency is provided between the first electric current injection region 1201 and the second electric current injection region 1202, in addition to the fundamental resonance state in which laser oscillation occurs at the total resonance frequency, there is a higher order resonance state in which an electric field distribution is different from the fundamental resonance state and a resonance wavelength is longer (the resonance frequency is lower) than the fundamental resonance state. Since the higher order resonance state has a larger loss than the fundamental resonance state, the higher order resonance state usually does not lead to oscillation. However, when a signal electric current having a modulation frequency corresponding to a resonance frequency difference between the two resonance states is supplied to only one of the first electric current injection region 1201 and the second electric current injection region 1202, it is considered that a weak coupling (photon-photon resonance) occurs between the fundamental resonance state and the higher order resonance state, thereby improving an efficiency of converting the signal electric current into a signal light.

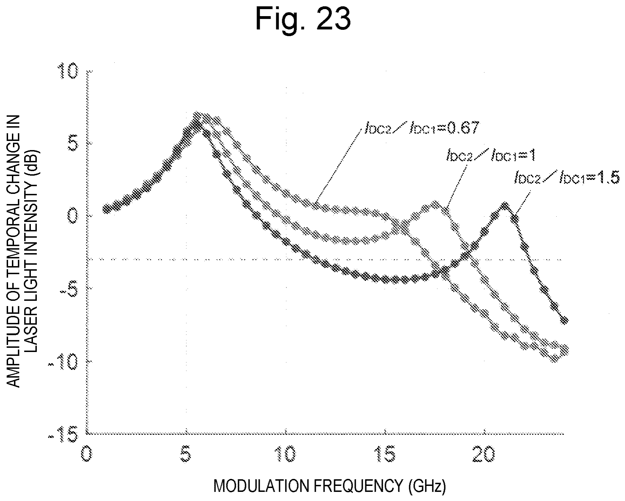

Such a change in amplitude of the temporal change in the intensity of the laser light due to the modulation frequency further changes depending on a ratio of the DC electric currents supplied to the first electric current injection region 1201 and the second electric current injection region 1202. According to the simulation result illustrated in Fig. 23, when the simulation is performed for three cases where ratios represented by a value I_{DC2}/I_{DC1} obtained by dividing a magnitude I_{DC2} of the DC electric current supplied to the second electric current injection region 1202 by a magnitude I_{DC1} of the DC electric current supplied to the first electric current injection region 1201 (excluding the radio-frequency electric current) are 0.67 (2/3), 1, and 1.5, as illustrated in Fig. 23, the larger I_{DC2}/I_{DC1} is, the larger the amplitude of the temporal change in the intensity of the laser light in the region where the modulation frequency is higher (particularly, 20 GHz or more) can be made.

In each of the examples described above, a waveform corresponding to the half cycle of the sine wave or to the sine wave is used as a part of the waveform of the signal electric current. However, as long as a positive or negative value can be maintained, a waveform having any shape such as a rectangular wave or a triangular wave can be used. In the First Specific Example, the electric current superimposed on the DC electric current is -1 times the first signal electric current for the second signal electric current, but other (including positive magnification) magnifications may be used.

Although the embodiment of the two-dimensional photonic crystal laser according to the present invention and the modifications thereof have been described above, the present invention is not limited to these embodiments and modifications, and further modifications can be made. Two or more of the plurality of configurations described in the above embodiment and modifications may be used in combination, or one or more of the plurality of configurations described in the above embodiment and modifications may be used in combination with another configuration.

### [Modes]

A person skilled in the art can understand that the previously described illustrative embodiment is a specific example of the following modes of the present invention.

(Clause 1) A two-dimensional photonic crystal laser according to one mode of the present invention includes:
a) an active layer;
b) a two-dimensional photonic crystal layer having a two-dimensional photonic crystal structure in which a different refractive index portion, which is a portion having a refractive index different from a refractive index of a plate-like base member laminated directly with the active layer or with another layer, is two-dimensionally and periodically disposed in the base member, the two-dimensional photonic crystal layer having a plurality of electric current injection regions having different resonance frequencies from each other; and
c) an electric current supply unit configured to supply a signal electric current in which a ratio of electric current intensity between the plurality of electric current injection regions changes with time into each of the plurality of electric current injection regions.

(Clause 2) A two-dimensional photonic crystal laser according to Clause 2 is the two-dimensional photonic crystal laser according to Clause 1, where, in the plurality of electric current injection regions, different refractive index portions are periodically disposed in a two-dimensional lattice shape of a same form with mutually different period lengths.

(Clause 3) A two-dimensional photonic crystal laser according to Clause 3 is the two-dimensional photonic crystal laser according to Clause 1 or 2, where, in the plurality of electric current injection regions, different refractive index portions are periodically disposed in a two-dimensional lattice shape of a same form at mutually different volume ratios.

(Clause 4) A two-dimensional photonic crystal laser according to Clause 4 is the two-dimensional photonic crystal laser according to any one of Clauses 1 to 3, where the plurality of electric current injection regions are different from each other in a material of one or both of the base member and the different refractive index portion.

(Clause 5) A two-dimensional photonic crystal laser according to Clause 5 is the two-dimensional photonic crystal laser according to any one of Clauses 1 to 4, where the plurality of electric current injection regions are different from each other in a magnitude of a DC component of the signal electric current.

(Clause 6) A two-dimensional photonic crystal laser according to Clause 6 is the two-dimensional photonic crystal laser according to any one of Clauses 1 to 5, where
the signal electric current is modulated at a predetermined modulation frequency, and
a difference between a maximum resonance frequency and a minimum resonance frequency among resonance frequencies in the plurality of electric current injection regions is larger than the modulation frequency.

(Clause 7) A two-dimensional photonic crystal laser according to Clause 7 is the two-dimensional photonic crystal laser according to any one of Clauses 1 to 6, where
the signal electric current supplied to two electric current injection regions of the plurality of electric current injection regions is an electric current in which a time-varying electric current having one of a waveform in which an electric current value maintains a positive or negative value and a waveform in which the electric current value maintains 0 is superimposed on a DC electric current for each predetermined modulation period, and
the time-varying electric current has phases opposite to each other in the two electric current injection regions.

(Clause 8) A two-dimensional photonic crystal laser according to Clause 8 is the two-dimensional photonic crystal laser according to any one of Clauses 1 to 6, where
the signal electric current supplied to one of the plurality of electric current injection regions is an electric current in which a time-varying electric current having one of a waveform in which an electric current value maintains a positive or negative value and a waveform in which the electric current value maintains 0 is superimposed on a DC electric current having a first magnitude for each predetermined modulation period, and
the signal electric current supplied to another one of the plurality of electric current injection regions is a DC electric current having a second magnitude.

(Clause 9) A two-dimensional photonic crystal laser according to Clause 9 is the two-dimensional photonic crystal laser according to any one of Clauses 1 to 8, where the different refractive index portion is a combination of two members having a different refractive index from a hole or the base member.

(Clause 10) An information transmission/reception system according to one mode of the present invention includes:
a transmitter having the two-dimensional photonic crystal laser according to any one of Clauses 1 to 9; and
a receiver including a photodetector configured to receive laser light emitted from the two-dimensional photonic crystal laser and to output a modulation signal that is a signal corresponding to a temporal change of a frequency of the laser light.

(Clause 11) A transmitter for the information transmission/reception system according to one mode of the present invention includes the two-dimensional photonic crystal laser according to any one of Clauses 1 to 9.

### REFERENCE SIGNS LIST

10... Two-Dimensional Photonic Crystal Laser
11... Active Layer
12... Two-Dimensional Photonic Crystal Layer
1201... First Electric Current Injection Region
1202... Second Electric Current Injection Region
121, 1211, 1212... Base Member
122... Different Refractive Index Portion
1221... First Different Refractive Index Portion
1222... Second Different Refractive Index Portion
13... Spacer Layer
141... First Cladding Layer
142... Second Cladding Layer
16... Substrate
171... Emission-Side Electrode
1710... Window
1711... First Emission-Side Split Electrode
1712... Second Emission-Side Split Electrode
172... Split Electrode
1721... First Split Electrode
1722... Second Split Electrode
1723... Counter Electrode
20... Information Transmission/Reception System
21... Transmitter
211... Signal Electric Current Generator
22... Receiver
221... Detector
222... Computer
311... First Electrode Pad
312... Second Electrode Pad
32... Grounding Pad
L... Laser Light

## Claims

1. A two-dimensional photonic crystal laser comprising:
a) an active layer;
b) a two-dimensional photonic crystal layer having a two-dimensional photonic crystal structure in which a different refractive index portion, which is a portion having a refractive index different from a refractive index of a plate-like base member laminated directly with the active layer or with another layer, is two-dimensionally and periodically disposed in the base member, the two-dimensional photonic crystal layer having a plurality of electric current injection regions having different resonance frequencies from each other; and
c) an electric current supply unit configured to supply a signal electric current in which a ratio of electric current intensity between the plurality of electric current injection regions changes with time into each of the plurality of electric current injection regions.

2. The two-dimensional photonic crystal laser according to claim 1, wherein, in the plurality of electric current injection regions, different refractive index portions are periodically disposed in a two-dimensional lattice shape of a same form with mutually different period lengths.

3. The two-dimensional photonic crystal laser according to claim 1, wherein, in the plurality of electric current injection regions, different refractive index portions are periodically disposed in a two-dimensional lattice shape of the same form at mutually different volume ratios.

4. The two-dimensional photonic crystal laser according to claim 1, wherein the plurality of electric current injection regions are different from each other in a material of one or both of the base member and the different refractive index portion.

5. The two-dimensional photonic crystal laser according to claim 1, wherein the plurality of electric current injection regions are different from each other in a magnitude of a DC component of the signal electric current.

6. The two-dimensional photonic crystal laser according to claim 1, wherein
the signal electric current is modulated at a predetermined modulation frequency, and
a difference between a maximum resonance frequency and a minimum resonance frequency among resonance frequencies in each of the plurality of electric current injection regions is larger than the modulation frequency.

7. The two-dimensional photonic crystal laser according to claim 1, wherein
the signal electric current supplied to two electric current injection regions of the plurality of electric current injection regions is an electric current in which a time-varying electric current having one of a waveform in which an electric current value maintains a positive or negative value and a waveform in which the electric current value maintains 0 is superimposed on a DC electric current for each predetermined modulation period, and
the time-varying electric currents are in opposite phases in the two electric current injection regions.

8. The two-dimensional photonic crystal laser according to claim 1, wherein
the signal electric current supplied to one of the plurality of electric current injection regions is an electric current in which a time-varying electric current having one of a waveform in which an electric current value maintains a positive or negative value and a waveform in which the electric current value maintains 0 is superimposed on a DC electric current having a first magnitude for each predetermined modulation period, and
the signal electric current supplied to another one of the plurality of electric current injection regions is a DC electric current having a second magnitude.

9. The two-dimensional photonic crystal laser according to claim 1, wherein the different refractive index portion is a combination of two members having a different refractive index from a hole or the base member.

10. An information transmission/reception system comprising:
a transmitter having the two-dimensional photonic crystal laser according to any one of claims 1 to 9; and
a receiver including a photodetector configured to receive laser light emitted from the two-dimensional photonic crystal laser and to output a modulation signal that is a signal corresponding to a temporal change of a frequency of the laser light.

11. A transmitter for an information transmission/reception system, comprising the two-dimensional photonic crystal laser according to any one of claims 1 to 9.
